# EUROPÄISCHE PATENTANMELDUNG

(11) **EP 0 646 554 A1**
(43) Veröffentlichungstag der Anmeldung: **05.04.1995**
(21) Anmeldenummer: 94113733.3
(22) Anmeldetag: 02.09.1994
(51) Int. Cl.: C04B 35/45, C04B 35/653, H01L 39/24

(54) **Massivteile aus Hochtemperatur-Supraleiter-Material**

(30) Priorität: 04.10.1993 DE 4333737; 01.02.1994 DE 4402991
(71) Anmelder: HOECHST AKTIENGESELLSCHAFT, D-65926 Frankfurt am Main (DE)
(72) Erfinder: Bock, Joachim, Dr., D-50374 Erftstadt (DE); Elschner, Steffen, Dr., D-65527 Niedernhausen (DE)

(57) **Zusammenfassung**

Massivteile aus Hochtemperatur-Supraleiter-Material bestehen aus den Oxiden des Bismuts, Strontiums, Calciums und Kupfers sowie aus den Sulfaten von Strontium und/oder Barium. Diese Massivteile weisen ein erhöhtes Stromtragevermögen auf, welches durch eine Vorzugsorientierung der Kristallite verursacht wird, wobei die kristallographische c-Achse senkrecht zum Temperaturgradienten während ihres Erstarrens aus der Schmelze steht.

Zur Herstellung dieser Massivteile vergießt man eine homogene Schmelze der Oxide des Bismuts, Strontiums, Calciums und Kupfers sowie den Sulfaten von Strontium und/oder Barium bei Temperaturen von 900 bis 1300 °C in Kokillen, läßt die Schmelze darin langsam erstarren und glüht anschließend die aus den Kokillen entnommenen Massivteile bei 700 bis 900 °C in sauerstoffhaltiger Atmosphäre. Dabei erfolgt das Vergießen der homogenen Schmelze in Kokillen mit mindestens zwei parallelen Wänden, wodurch in den Massivteilen sowohl nach ihrem Erstarren als auch nach ihrem Glühen eine kristallographische Vorzugsorientierung der Kristallite entsteht.

## Beschreibung

Die vorliegende Erfindung betrifft aus den Oxiden des Bismuts, Strontiums, Calciums und Kupfers sowie aus den Sulfaten von Strontium und/oder Barium bestehende Massivteile aus Hochtemperatur-Supraleiter-Material mit erhöhtem Stromtragevermögen.

Massivteile aus Hochtemperatur-Supraleiter-Material sind von Interesse für Anwendungen wie z.B. Strombegrenzer in der Starkstromtechnik und Stromzuführungen in der Magnettechnik. Da es sich bei allen bisher bekannten Hochtemperatursupraleitern mit einer Sprungtemperatur oberhalb des Siedepunktes des flüssigen Stickstoffs (77 K) um keramische Substanzen handelt, werden Massivteile daraus häufig über keramische Formgebungsprozesse fabriziert. Dazu werden die Substanzen zunächst in Form von Pulvern oder als granulares Material hergestellt. In einem weiteren Schritt wird ein keramischer Formkörper gefertigt, der dann noch einer abschließenden Wärmebehandlung unterzogen werden muß.

Selbst wenn bei der keramischen Formgebung keine organischen Hilfsstoffe wie Binder etc. verwendet werden, sind die elektrischen und magnetischen Eigenschaften der so hergestellten Massivteile für technische Zwecke unzureichend, die kritischen Stromdichten dieser Massivteile sind im allgemeinen deutlich kleiner als 1 kA/cm². Darüberhinaus ist an solchen Proben schon bei Feldstärken unterhalb von 100 Gauss bereits ein drastischer Rückgang der kritischen Stromdichten zu verzeichnen. Im Unterschied dazu liegen die kritischen Stromdichten in supraleitenden Körnern und in orientiert gewachsenen Dünnfilmen im Bereich von 1000 kA/cm². Der Grund für die geringere Qualität der Keramikproben aus Hochtemperatur-Supraleiter-Material liegt darin, daß der supraleitende Strom die Korngrenzen nicht ungehindert passieren kann, was zum einen mit der geringen Konnektivität der supraleitenden Körner und zum anderen mit ihrer beliebigen Orientierung untereinander zusammenhängt.

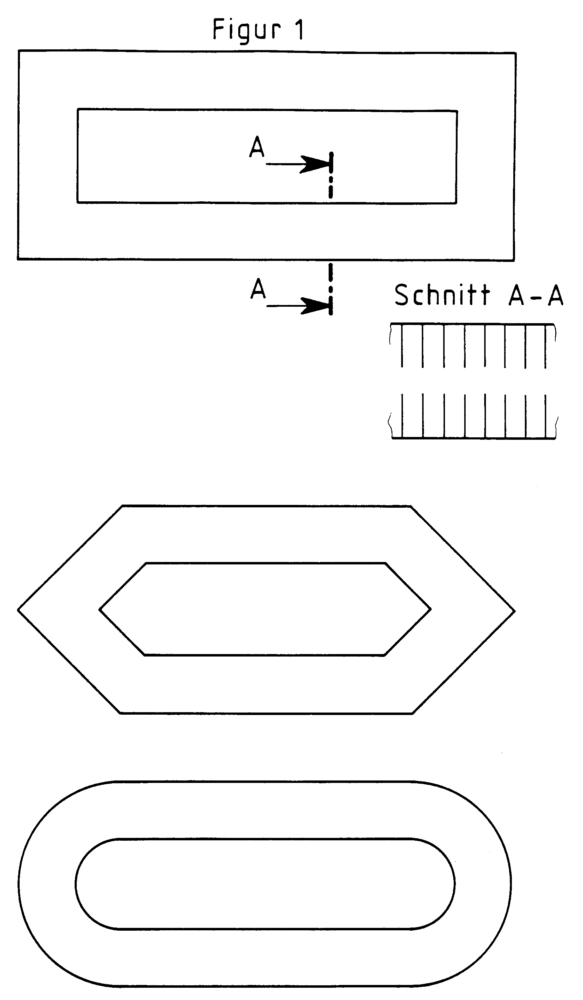

Aus der DE-OS 41 24 823 sind massive Hochtemperatur-Supraleiter bekannt, welche aus den Oxiden des Bismuts, Strontiums, Calciums und Kupfers und gegebenenfalls des Bleis sowie aus Sulfaten von Strontium und/oder Barium bestehen. Zur Herstellung der Hochtemperatur-Supraleiter erhitzt man die genannten Oxide und Sulfate auf Temperaturen von 870 bis 1300 °C unter Bildung einer homogenen Schmelze. Die homogene Schmelze gießt man in Kokillen ab und läßt sie darin langsam erstarren. Schließlich glüht man die aus den Kokillen entnommenen Formkörper bei Temperaturen von 700 bis 900 °C in sauerstoffhaltiger Atmosphäre. Diese Herstellungsweise für Massivteile vermeidet nachteilige Materialeigenschaften der durch keramische Formgebung von granularem Material erhaltenen Massivteile: Die nach der Schmelzgußmethode hergestellten Teile zeigen nicht den drastischen Abfall der kritischen Stromdichte in Magnetfeldern auf Grund von schlechter Koppelung, sondern sind charakterisiert durch gute Koppelung zwischen den Körnern des Gefüges (vergl. Supercond. Sci. Technol. 6, (1993), Seiten 413 bis 420, insbesondere Figur 1). Die Ursache dafür liegt in der Besonderheit der Schmelzgußmethode: Beim Temperprozeß tritt in den Massivteilen eine partiell flüssige Phase auf, wodurch die Konnektivität der Körner verbessert wird.

In der Literatur sind verschiedene Verfahren beschrieben, in Massivproben die Orientierung der supraleitenden Körner untereinander zu verbessern. Dies wird dadurch erreicht, daß während des Wachstumprozesses der supraleitenden Phase ein Gradient auf eine irgendwie verdichtete oder gesinterte Massivprobe wirkt. Dies kann durch Zonenschmelzen, d. h. durch Anlegen eines steilen Temperaturgradienten, beispielsweise 100 K/cm, am Ort der Probe erfolgen. Dabei ist immer zu beachten, daß sich die Cuprate im Hochtemperatur-Supraleiter-Material beim Aufschmelzen unter Sauerstoffabgabe peritektisch zersetzen, d. h. umgekehrt muß während des Wachstumsprozesses der Kristallite Sauerstoff in die Probe diffundieren. Die Wachstumsprozesse sind dadurch langsam, die Wachstumsraten z.B. für Stäbchen, die durch einen Temperaturgradienten gezogen werden, liegen im Bereich von einigen mm/Tag. Andere Verfahren beschreiben die Verwendung starker Magnetfelder während des Wachstumsprozesses bei 900 bis 1000 °C. Hierdurch läßt sich für Yttriumbariumcuprat eine gewisse Orientierung der Kristallite erzielen (vergl. D. Bourgault et al. in: Physica C, 194 (1992) Seiten 171 bis 176).

Es ist Aufgabe der vorliegenden Erfindung, aus den Oxiden des Bismuts, Strontiums, Calciums und Kupfers sowie aus den Sulfaten von Strontium und/oder Barium bestehende Massivteile aus Hochtemperatur-Supraleiter-Material mit erhöhtem Stromtragevermögen anzugeben, welche eine hohe Konnektivität und gleichzeitig eine verbesserte Orientierung der supraleitenden Körner untereinander aufweisen. Die erfindungsgemäßen Massivteile sind daher durch eine Vorzugsorientierung der hochtemperatursupraleitenden BiSrCaCuO-Kristallite gekennzeichnet, wobei die kristallographische c-Achse senkrecht zum Temperaturgradienten während ihres Erstarrens aus der Schmelze steht.

Die Erfindung betrifft weiterhin ein Verfahren zur Herstellung der Massivteile aus Hochtemperatur-Supraleiter-Material durch Vergießen einer homogenen Schmelze der Oxide des Bismuts, Strontiums, Calciums und Kupfers sowie den Sulfaten von Strontium und/oder Barium mit Temperaturen von 900 bis 1300 °C in Kokillen, langsames Erstarren darin und anschließendes Glühen der aus den Kokillen entnommenen Massivteile bei 700 bis 900 °C in sauerstoffhaltiger Atmosphäre und ist dadurch gekennzeichnet, daß das Vergiessen der homogenen Schmelze in Kokillen mit mindestens zwei parallelen Wänden erfolgt, wodurch in den Massivteilen sowohl nach ihrem Erstarren als auch nach ihrem Glühen eine kristallographische Vorzugsorientierung der Kristallite entsteht, wobei in den geglühten Massivteilen die kristallographische c-Achse der hochtemperatursupraleitenden BiSrCaCuO-Phase senkrecht zum Temperaturgradienten während des Erstarrens der Schmelze steht.

Dieses Verfahren kann auch dadurch abgeändert sein, daß das Vergießen in Kokillen mit rundem Profil erfolgt und daß aus den aus den Kokillen entnommenen Massivteilen entsprechende Segmente herausgeschnitten werden.

Schließlich kann das abgeänderte Verfahren auch noch dadurch ausgestaltet sein, daß
a) das Herausschneiden der Segmente mit einer Diamantsäge erfolgt;
b) aus Rundstäben Stäbe mit Rechteckprofil herausgeschnitten werden;
c) Rohre in ihrer Längsrichtung in etwa gleich große Segmente zerlegt werden;
d) die Segmente sternförmig angeordnet sind, wobei der Außendurchmesser dieser Anordnung etwa dem Außendurchmesser des ursprünglichen Rohres entspricht.

Der kritische Strom von hochtemperatursupraleitenden Stäben aus Rechteckprofil ist unter dem Einfluß eines äußeren Feldes - bei günstiger Orientierung zum magnetischen Feldvektor - deutlich höher als von Stäben mit vergleichbar großem, jedoch rundem Querschnitt.

Die aus hochtemperatursupraleitenden Rundstäben herausgeschnittenen Rechtecksegmente verhalten sich in bezug auf ihren kritischen Strom in einem äußeren Magnetfeld anisotrop.

Die durch Zerlegen eines Rohres aus Hochtemperatur-Supraleiter-Material in seiner Längsrichtung erhaltenen und sternförmig angeordneten Segmente erreichen unter Eigenfeldeinfluß einen doppelt so hohen kritischen Strom wie das ursprüngliche Rohr.

Überraschenderweise induziert die Vorzugsorientierung der Kristallite in der erstarrten Schmelze auch eine Vorzugsorientierung der sich erst während der Temperung bildenden Hochtemperatur-Supraleiter-Phase Dies gilt, obwohl während der Temperung ein partiell schmelzflüssiger Zustand durchlaufen wird und obwohl hier die Hochtemperatur-Supraleiter-Phase erst völlig neu entsteht. Aufgrund des involvierten Schmelzvorganges beim Tempern liegt darüberhinaus eine bessere Konnektivität zwischen den Körnern vor.

Durch die Verwendung von günstigen Kokillenformen (Rechteckprofil) oder durch Herausschneiden entsprechender Segmente aus Formen mit rundem Profil (Rundstab oder Rohr) werden beim Verfahren gemäß der Erfindung auf direktem Wege supraleitende Massivteile mit einer kristallinen Vorzugsorientierung erhalten. So hergestellte Teile haben aufgrund dieser Vorzugsorientierung entweder ein höheres Stromtragevermögen im Eigenfeld oder, bei entsprechender Ausrichtung zum Feldvektor, ein höheres Stromtragevermögen unter Einfluß eines äußeren Magnetfeldes.

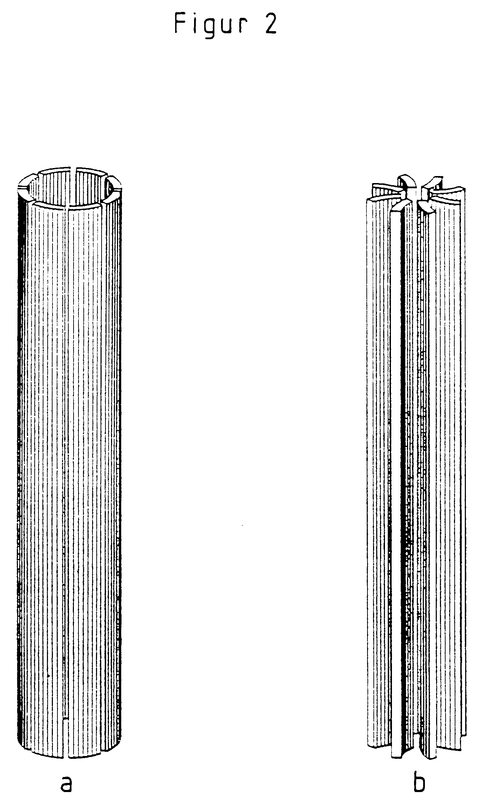

In der beigefügten Zeichnung sind in Figur 1 verschiedene Kokillen dargestellt, welche beim erfindungsgemäßen Verfahren anwendbar sind, während Figur 2a ein in Segmente zerschnittenes Rohr aus Hochtemperatur-Supraleiter-Material zeigt. Diese Segmente sind in Figur 2b in erfindungsgemäßer Weise sternförmig unter Bildung eines Hochtemperatur-Supraleiters mit anisotropen Eigenschaften angeordnet, wobei sein Außendurchmesser dem Außendurchmesser des ursprünglichen Rohres etwa gleich ist.

### Beispiel 1 (Vergleichsbeispiel)

Nach dem Verfahren gemäß der DE-OS 41 24 823 wurde eine Serie von mehr als 100 Rundstäben (⌀ 8 mm, Längen variierend zwischen 50 und 200 mm) durch Vergießen der Schmelze in einseitig geschlossene Quarzrohre mit rundem Querschnitt hergestellt. Nach dem Verfahren gemäß der DE-OS 41 18 988 wurden in den Quarzkokillen vor dem Vergießen Silberbleche montiert und so die Stäbe gleichzeitig mit integrierten Stromkontakten versehen, über die ein Gleichstrom eingespeist wurde. Als durchschnittliche kritische Stromdichte wurden 930 A/cm² (bei 77 K, Spannungskriterium 1 µV/cm) erreicht. Die Standardabweichung bei der gesamten Serie lag bei nur 50 A/cm².

An mehreren so hergestellten Rundstäben (⌀ 8 mm) wurde der kritische Strom unter dem Einfluß eines magnetischen Feldes bis zu 1 kGauss gemessen. Dabei ergab sich immer ein vergleichsweise flach verlaufender linearer Abfall im magnetischen Feld. Um einen eventuellen Einfluß der Richtung des Magnetfeldes auf die Probe zu bekommen, wurde die Transportstrommessung an einem Stab wiederholt, nachdem der Stab um seine Längsachse um 10 ° aus der ursprünglichen Position gedreht worden war. Die Messungen wurden nach weiteren Drehungen in 10 ° Schritten wiederholt, bis der Stab um 180 ° aus seiner ursprünglichen Position herausgedreht worden war. Bei allen Messungen wurden gleiche Stromdichten im Nullfeld und ein vollständig identischer Verlauf des kritischen Stromes im Magnetfeld gefunden, d. h. der massive Rundstab verhält sich über seinem gesamten Umfang vollkommen isotrop in Bezug auf das angelegte Magnetfeld.

### Beispiel 2 (Vergleichsbeispiel)

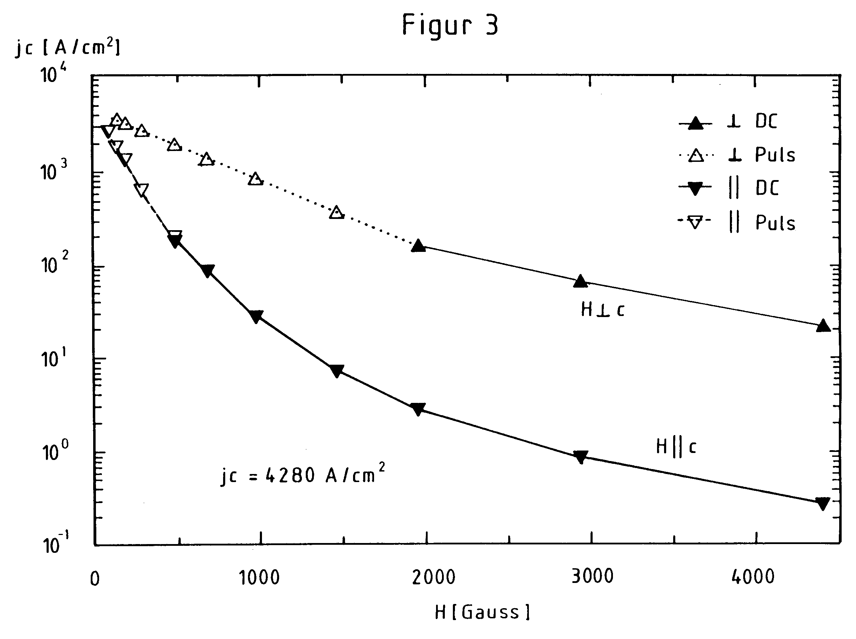

Aus einem nach Beispiel 1 hergestellten Rundstab wurde in seiner Längsrichtung zentral eine flache Scheibe (Abmessungen: o,7 x 8 x 4o mm³) herausgeschnitten, noch einmal längs geteilt und daraus ein Stäbchen präpariert (Abmessungen: 1 x o,7 x 4o mm³) . Das Stäbchen war so aus dem Rundstab herausgeschnitten, daß die kristallographische c-Achse der Kristallplättchen in einer Ebene mit der Längsachse des Stäbchens lag. An diesem Stäbchen wurde mit Hilfe von Gleichstrom- und Pulsmessungen der Verlauf des kritischen Stromes im Magnetfeld bis 4,5 kGauss bestimmt, wobei - analog Beispiel 1 - das Stäbchen zur Untersuchung des Einflusses der Orientierung des magnetischen Feldvektors im Feld gedreht wurde. Je nach Ausrichtung zum magnetischen Feld ergab sich für die günstigste Ausrichtung ein etwa 8o mal höherer kritischer Strom als bei einer Ausrichtung senkrecht dazu, wodurch der Nachweis für anisotropes Verhalten des Stäbchens erbracht wurde (vergl. Figur 3).

### Beispiel 3 (gemäß der Erfindung)

Schmelzen analog Beispiel 1 wurden in Quarzrohre mit einem rechteckigen Querschnitt (8 x 22 mm² Innenmaße) vergossen, wodurch nach dem Erstarren Profilstäbe erhalten wurden. In die Quarzkokillen war Silberfolie montiert und die Temperung erfolgte zweistufig. Entsprechend Beispiel 1 wurde der Stab um seine Längsachse gedreht und der kritische Strom in verschiedenen Positionen hierzu bestimmt. Hierbei zeigte sich anisotropes Verhalten.

### Beispiel 4 (gemäß der Erfindung)

Von einem nach Beispiel 3 hergestellten Profilstab wurden die Ränder im Bereich der kurzen Kanten weggeschnitten. Bei der Messung des kritischen Stromes in Abhängigkeit von der Drehung des Profilstabes ergaben sich bei einer vollen Umdrehung ausgeprägte Extremwerte ohne Zwischenmaxima. Bei einem Feld von 15oo Gauss war die kritische Stromdichte im Profilstab in seiner günstigsten Position (Feld senkrecht zur breiten Seite des Profils) doppelt so hoch wie im Rundstab gemäß Beispiel 1.

### Beispiel 5 (gemäß der Erfindung)

In eine aufklappbare Cu-Kokille der Abmessungen 6 x 150 x 200 mm³ wurde eine Schmelze gemäß Beispiel 1 vergossen. Der Gußkörper wurde nach Erkalten der Schmelze entnommen und in sauerstoffhaltiger Atmosphäre getempert. Anschließend wurde der Gußblock längs in Streifen mit einem Querschnitt von 6 x 2 mm² geschnitten, die aus dem seitlichen Randbereich stammenden Streifen wurden verworfen. Die verbliebenen Streifen wiesen bei Messung des kritischen Stromes in Abhängigkeit zur Orientierung eines äußeren Magnetfeldes ein deutliches anisotropes Verhalten auf.

### Beispiel 6 (Vergleichsbeispiel)

Durch Schleudergießen wurde ein Hochtemperatur-Supraleiter-Rohr (⌀ 35 mm, L 200 mm; A 4,8 cm²) hergestellt und zur Stromeinspeisung beidseitig mit eingeschmolzenen Silberkontakten versehen. Die Messung des kritischen Stromes ohne äußeres Magnetfeld ergab 2000 A (77 K, 1 µV/cm). Die Messung bei Anwendung eines äußeren Magnetfeldes ergab isotropes Verhalten bezüglich der Drehung des Rohres um seine Längsachse.

### Beispiel 7 (gemäß der Erfindung)

Das nach Beispiel 6 hergestellte Rohr wurde mit Hilfe einer Diamantsäge längs in acht gleich große Segmente zerlegt. Die Messung des kritischen Stromes an einzelnen Segmenten ergab mit durchschnittlich 910 A/cm² ohne äußeres Feld einen doppelt so hohen Wert als den für das komplette Rohr nach Beispiel 5 ermittelten Wert von 420 A/cm². Ursache hierfür ist offensichtlich der geringere Eigenfeldeffekt im Falle der Segmente mit kleinerem Querschnitt.

### Beispiel 8 (gemäß der Erfindung)

Die acht nach Beispiel 7 hergestellten Segmente wurden an ihren oberen und unteren Enden sternförmig in Kupferhalter eingelötet. Der Außenumfang dieser Anordnung entspricht dem Außendurchmesser des ursprünglichen Rohres. Die Bestimmung des kritischen Stromes ergab mit 3830 A (77 K, 1 µV/cm) nahezu den doppelten Wert für den Fall, daß außer dem Eigenfeld des Leiters kein zusätzliches Feld wirkte.

In dieser Anordnung liegt die ursprünglich radiale Richtung des Rohres parallel zum Umfang und umgekehrt. Das rotationssymmetrische Eigenfeld liegt so parallel zu den Plättchenebenen der Kristallite (und damit zu der kristallographischen a-b-Ebene mit den Cu-O-Schichten). Dadurch wird, verglichen mit dem ursprünglichen Rohr, durch den Einfluß des Eigenfeldes ein erheblich geringerer Rückgang der kritischen Stromdichte beobachtet.

## Patentansprüche

1. Aus den Oxiden des Bismuts, Strontiums, Calciums und Kupfers sowie aus den Sulfaten von Strontium und/oder Barium bestehende Massivteile aus Hochtemperatur-Supraleiter-Material mit erhöhtem Stromtragevermögen, gekennzeichnet durch eine Vorzugsorientierung der Kristallite der Massivteile dergestalt, daß die kristallographische c-Achse senkrecht zum Temperaturgradienten während ihres Erstarrens aus der Schmelze steht.

2. Verfahren zur Herstellung der Massivteile aus Hochtemperatur-Supraleiter-Material nach Anspruch 1 durch Vergießen einer homogenen Schmelze der Oxide des Bismuts, Strontiums, Calciums und Kupfers sowie den Sulfaten von Strontium und/oder Barium mit Temperaturen von 900 bis 1300 °C in Kokillen, langsames Erstarren darin und anschließendes Glühen der aus den Kokillen entnommenen Massivteile bei 700 bis 900 °C in sauerstoffhaltiger Atmosphäre, dadurch gekennzeichnet, daß das Vergießen der homogenen Schmelze in Kokillen mit mindestens zwei parallelen Wänden erfolgt, wodurch in den Massivteilen sowohl nach ihrem Erstarren als auch nach ihrem Glühen eine kristallographische Vorzugsorientierung der Kristallite entsteht, wobei in den geglühten Massivteilen die kristallographische c-Achse der hochtemperatursupraleitenden BiSrCaCuO-Phase senkrecht zum Temperaturgradienten während des Erstarrens der Schmelze steht.

3. Abänderung des Verfahrens nach Anspruch 2, dadurch gekennzeichnet, daß das Vergießen in Kokillen mit rundem Profil erfolgt und daß aus den aus den Kokillen entnommenen Massivteilen entsprechende Segmente herausgeschnitten werden.

4. Verfahren nach Anspruch 3, dadurch gekennzeichnet, daß das Herausschneiden der Segmente mit einer Diamantsäge erfolgt.

5. Verfahren nach Anspruch 3 oder 4, dadurch gekennzeichnet, daß aus Rundstäben Stäbe mit Rechteckprofil herausgeschnitten werden.

6. Verfahren nach Anspruch 3 oder 4, dadurch gekennzeichnet, daß Rohre in ihrer Längsrichtung in etwa gleich große Segmente zerlegt werden.

7. Verfahren nach Anspruch 6, dadurch gekennzeichnet, daß die Segmente sternförmig angeordnet sind, wobei der Außendurchmesser dieser Anordnung etwa dem Außendurchmesser des ursprünglichen Rohres entspricht.
